# EUROPÄISCHE PATENTSCHRIFT

(11) **EP 1 363 919 B1**
(45) Veröffentlichungstag und Bekanntmachung des Hinweises auf die Patenterteilung: **04.05.2005**
(21) Anmeldenummer: 02714019.3
(22) Anmeldetag: 15.02.2002
(51) Int. Cl.: C07F 5/04, C09K 11/07, H01L 51/30

(54) **ORGANISCHE ROT ELEKTROLUMINESZIERENDE CHROMOPHORE, HERSTELLUNGSVERFAHREN UND VERWENDUNGEN DAZU**
ORGANIC RED ELECTROLUMINESCENT CHROMOPHORES, METHOD FOR THE PRODUCTION AND USE THEREOF
CHROMOPHORES ORGANIQUES ELECTROLUMINESCENTS ROUGES, LEUR PROCEDE DE PRODUCTION ET LEUR UTILISATION

(30) Priorität: 27.02.2001 DE 10109333
(43) Veröffentlichungstag der Anmeldung: 26.11.2003
(73) Patentinhaber: SIEMENS AKTIENGESELLSCHAFT, 80333 München (DE)
(72) Erfinder: ROGLER, Wolfgang, 91096 Möhrendorf (DE); KANITZ, Andreas, 91315 Höchstadt (DE); HARTMANN, Horst, 06217 Merseburg (DE); STEFFEN, Kay, 79356 Eichstetten a. Kaiserstuhl (DE)
(86) Internationale Anmeldenummer: PCT/DE2002/000550
(87) Internationale Veröffentlichungsnummer: WO 2002/068431

(56) Entgegenhaltungen:
- EP-A- 0 969 531
- EP-A- 1 074 602
- WO-A-94/19355

## Beschreibung

Die Erfindung betrifft Chromophore mit halbleitenden Eigenschaften, deren Herstellung und ihre Anwendung als Luminophore in organischen Leuchtdioden (OLEDS) und organischen Solarzellen.

In den Anmeldungen DE 10002423 und DE 10002424 sowie in den Anmeldungen DE 10038436 und DE 10038437 (alle bisher unveröffentlicht) werden bereits neue organische Halbleitermaterialien vorgestellt, die auch als Festkörper hohe Fluoreszenz zeigen und glasartige Phasen bilden.

Die neuen Halbleitermaterialien sind zur Abdeckung des langwellig emittierenden Spektralbereiches (orange bis rot) geeignet und gehören zu den "small molecules", obwohl sie sich auch durch spin coating verarbeiten lassen. Die Materialien eignen sich sowohl zum Aufbau organischer lichtemittierender Dioden (OLEDs) als auch zum Aufbau organischer photovoltaischer Elemente und schließlich auch zum Aufbau weiterer organischer elektronischer Bauelemente, wobei diese Materialien sowohl in Loch- als auch in Elektronentransportschichten und in Emitterschichten Verwendung finden können.

Die Materialien sind präperativ in hohen Ausbeuten zugänglich und leiten sich von 2-N,N-Di(het)arylamino-thiophen- und/oder -thiazol-derivaten ab.

Es besteht weiterhin der Bedarf an neuen organischen halbleitenden und/oder emittierenden Materialien für die verschiedensten Verwendungen in organischen Bauelementen und Leuchtdioden.

Die erfindungsgemäßen neuen Materialien erweitern die Palette an intensiv lumineszierenden Borkomplexverbindungen, die in der Anmeldung DE 10105916 beansprucht werden.

Aufgabe der Erfindung ist es, neue organische, thermisch und photochemisch stabile, langwellig elektrolumineszierende Verbindungen zu schaffen, die in organischen Leuchtdioden und /oder organischen elektronischen Bauelementen verwendet werden können, die präparativ gut zugänglich und in Massenfertigungsprozessen leicht verarbeitbar sind.

Gegenstand der Erfindung ist eine hochkondensierte Borkomplexverbindung der allgemeinen Struktur **I**. 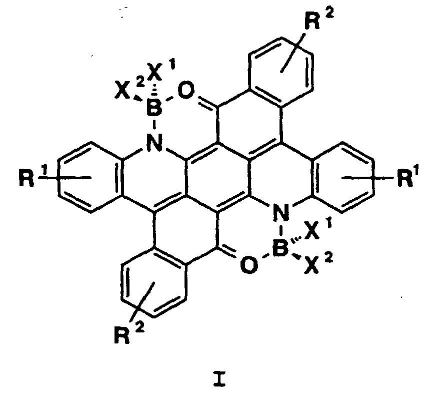 wobei Folgendes gilt:
R¹ und R² die, unabhängig voneinander gleich oder verschieden sein können, stehen für Wasserstoff, Halogen, Pseudohalogen, eine Nitril- und/oder Nitrogruppe, ein unsubstituiertes oder durch Alkyl, durch Aryl sowie Aryl mit zumindest einem nicht-Kohlenstoffatom substituiertes -NR³R⁴, -OR⁵, -PR³R⁴ sowie -SR⁶ und/oder für einen ankondensierten carbocyclischen oder heterocyclischen Ring, wobei im Fall, dass R³ bis R⁶ Alkyl ist, diese Reste verzweigt oder unverzweigt sein können, 1 bis 20 C-Atome enthalten können und verschiedene funktionelle Gruppen mit N,O, S und/oder P-Atomen enthalten können;
X¹ und X² die, unabhängig voneinander gleich oder verschieden sein können, stehen für Halogen, dabei vorzugsweise Fluor, Alkyl- oder Aryloxy, wobei die Alkylgruppierungen verzweigt oder unverzweigt 1 bis 20 C-Atome und verschiedene funktionelle Gruppen mit N,O, S und/oder P-Atomen enthalten können
oder
beide gemeinsam, durch einen zumindest zweizähnigen Liganden mit dem Boratom einen Cyclus bilden, wobei der zumindest zweizähnige Ligand Hydroxy- und/oder Carbonsäuregruppen haben kann und vorzugsweise ein Diol, eine Hydroxycarbonsäure oder eine Dicarbonsäure, wie -OC₂H₄O-, -OC₃H₆O-, Glykolat, Laktat, Tartrat, Sylicylat, Mandelat, Benzilat, 1,2- oder 2,3-Hydroxynaphthoat, Oxalat, Malonat, Alkylmalonat oder Dialkylmalonat ist.

Ausserdem ist Gegenstand der Erfindung ein Verfahren zur Herstellung der Borkomplexverbindungen I, aus einem Diazaperylen **II** 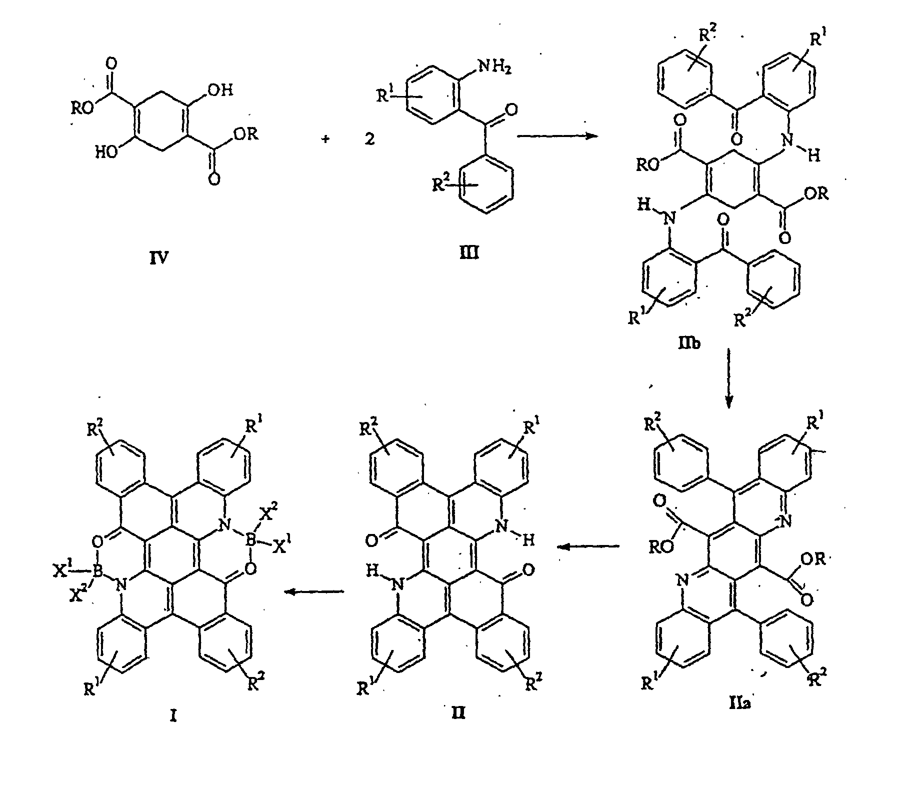 durch Umsetzung mit zumindest einem Borester, einer Carbonsäure, einer Di- oder Oligocarbonsäure, einer hydroxysubstituierten Carbonsäure und/oder mit einem komplexen Addukt eines Borhalogenids.

Schließlich ist Gegenstand der Erfindung die Verwendung einer elektrolumineszierenden hochkondensierten Borkomplexverbindung I als organisches halbleitendes Material in einem organischen elektronischen Bauelement.

In den neuen erfindungsgemäßen langwellig emittierenden Luminophoren wird die Kristallisationstendenz durch den zusätzlichen Einbau von Spiroelementen zurückgedrängt, so daß die dadurch erzeugte Dreidimensionalität der Chromophore die Stapelung der Moleküle zu Kristallen verhindert bzw. einschränkt.

In den Borkomplexverbindungen wirken die Boratome wie Spirozentren, begünstigen die Bildung glasartiger Phasen des Systems und verhindern die unerwünschte Kristallisation, die eine Verringerung der fluoreszierenden Eigenschaften des Systems bewirkt. Die positiven Eigenschaften von Spirozentren in organischen halbleitenden Materialien sind bereits bekannt.

### Reaktionsschema:

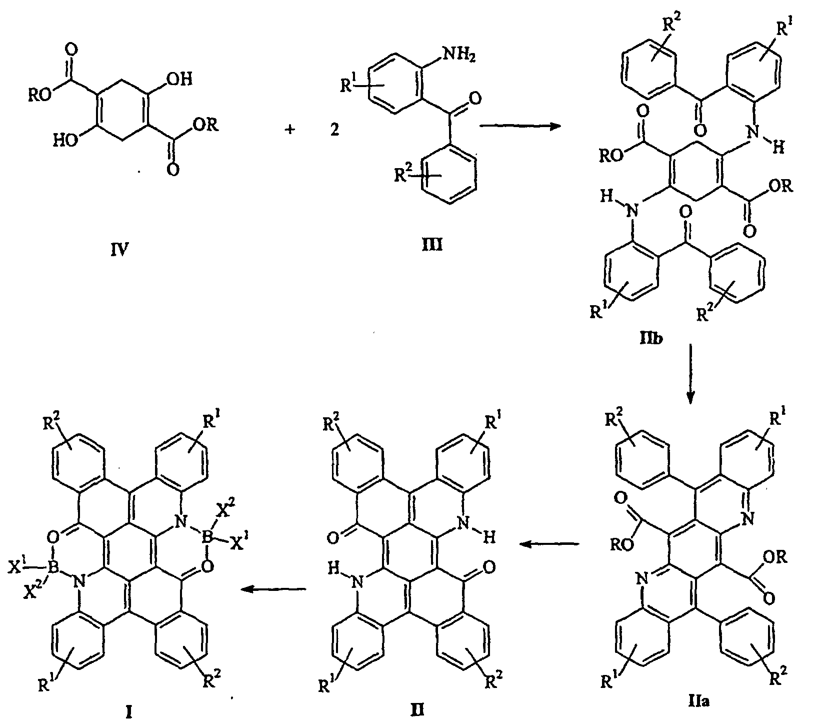

Die Herstellung der erfindungsgemäßen, hochkondensierten Borkomplexverbindungen des Typs **I** erfolgt aus den in der Literatur (K. Kitahara, H. Nishi, J. Heterocyclic Chem. **25** (1988) 1063) beschriebenen Verbindungen vom Typ **II**, in denen die Reste R¹ und R² sowie X¹ und X² die vorgenannte Bedeutung haben, nach an sich bekannten Verfahrensweisen, durch ihre Umsetzung mit geeigneten Borverbindungen, gegebenenfalls in Gegenwart eines geeigneten Koreagenzes sowie in Gegenwart eines geeigneten Lösungsmittels bei erhöhter Temperatur.

Als geeignete Borverbindungen zur Umsetzung mit **II** haben sich insbesondere Borester von Carbonsäuren, vorzugsweise Di- oder Oligocarbonsäuren und/oder hydroxy-substituierte Carbonsäuren und komplexe Addukte von Borhalogeniden mit elektronendonatorfähigen Lösungsmitteln erwiesen.

Die neuartigen borkomplexierten Tetraaryl-diazaperylen Heterocyclen vom Typ **I** eignen sich wegen ihrer hohen thermischen und photochemischen Stabilität und ihrer Fähigkeit, bei höherer Temperatur im Hochvakuum unzersetzt verdampfbar zu sein sowie ihrer Fähigkeit zur Elektrolumineszenz in vorteilhafter Weise als Emittermaterialien zur Herstellung von organischen lichtemittierenden Dioden (OLEDs) und als photochemisch stabiles, photoaktives Material in organischen Solarzellen und/oder in anderen organischen elektronischen Bauelementen. Die thermische Zersetzung dieser Materialien findet erst bei Temperaturen >470°C statt.

### Ausführungsbeispiele:

Die folgenden Beispiele sollen die Erfindung näher erläutern. Die Beispiele 1 bis 3 beschreiben dabei die zur Herstellung der erfindungsgemäßen hochkondensierten Borkomplexverbindungen des Typs **I** erforderlichen Synthons des Typs **II**. Die Beispiele 4 - 8 beschreiben die Herstellung der borkomplexierten hochkondensierten Heterocyclen aus der Klasse der Tetaaryldiazaperylene **I**.

### Beispiel 1:

### Synthese des Diazaperylen Typ II/1 R¹ = R² = H

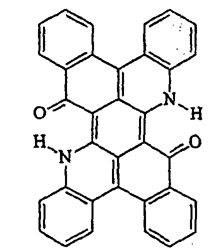

0,1 mol 2-Amino-benzophenon III und 0,05 Mol Succinylobernsteinsäure-diethylester IV werden in 50 ml Ethanol und 1 ml Salzsäure 5 h unter Rückfluß erhitzt. Das nach dem Abkühlen aus der Reaktionslösung in einer Ausbeute von 70 % ausfallende Produkt IIa wird abgesaugt, getrocknet und anschließend in 25 ml 1-Chlornaphthalin 30 min unter Rückfluß erhitzt. Das dabei anfallende Produkt II/1 wird nach dem Erkalten durch Absaugen isoliert und zur Reinigung mit ca. 200 ml Methanol gewaschen. Ausbeute 70%; mp 405°C. Das Produkt weist in ortho-Dichlorbenzol ein Absorptionsmaximum von 648nm und ein Emissionsmaximum von 704nm auf.

### Beispiel 2:

### Synthese des Diazaperylen Typ II/2 R¹ = Cl R² = H

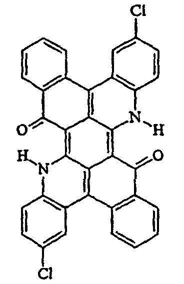

Analog Beispiel 1 werden 0,1 Mol 2-Amino-5-chlor-benzophenon III und 0,05 Mol Succinylobernsteinsäure-diethylester IV in 50 ml Ethanol und 1 ml Salzsäure umgesetzt. Das nach dem Abkühlen aus der Reaktionslösung ausfallende Produkt IIa wird abgesaugt, getrocknet und anschließend in 25 ml 1-Chlornaphthalin 30 min unter Rückfluß erhitzt. Das dabei anfallende Produkt II/2 wird nach dem Erkalten durch Absaugen isoliert und zur Reinigung mit ca. 200 ml Methanol gewaschen. Ausbeute 82%; mp 470°C. Das Produkt weist in o-Dichlorbenzol ein Absorptionsmaximum von 649nm und ein Emissionsmaximum von 706nm auf.

### Beispiel 3:

### Synthese des Diazaperylen Typ II/3 R¹ = R² = Cl

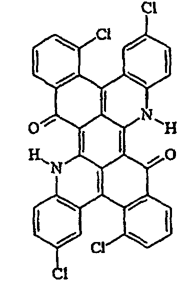

Analog Beispiel 1 werden 0,1 Mol 2-Amino-2',5-dichlor-benzophenon III und 0,05 Mol Succinylobernsteinsäure-diethylester IV in 50 ml Ethanol und 1 ml Salzsäure umgesetzt. Das nach dem Abkühlen aus der Reaktionslösung ausfallende Produkt IIa wird abgesaugt, getrocknet und anschließend in 25 ml 1-Chlornaphthalin 30 min unter Rückfluß erhitzt. Das dabei anfallende Produkt II/3 wird nach dem Erkalten durch Absaugen isoliert und zur Reinigung mit ca. 200 ml Methanol gewaschen. Ausbeute 85%; mp >360°C. Das Produkt weist in o-Dichlorbenzol ein Absorptionsmaximum von 656nm und ein Emissionsmaximum von 708nm auf.

### Beispiel 4:

### Synthese des borkomplexierten Diazaperylen Typ I/1 R¹ = R² = H; X¹ = X² = -O-CO-CH₃

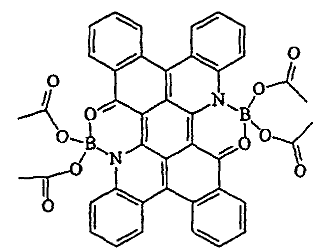

Zu einer Lösung von Boracetat in einer Essigsäure/Acetanhydrid Mischung, hergestellt durch Auflösen von 10 g Borsäure in 250ml Acetanhydrid, werden 0,05 Mol der Ausgangsverbindung **II/1** zugegeben. Es wird so lange unter Rückfluß erhitzt, bis eine fast klare Lösung entstanden ist. Nach einer Heißfiltration läßt man Abkühlen und isoliert das ausgefallene Produkt I/1 durch Absaugen. Ausbeute 95%; mp 380°C. Das Produkt weist in Aceton ein Absorptionsmaximum von 567nm und ein Emissionsmaximum von 613nm auf.

### Beispiel 5:

### Synthese des borkomplexierten Diazaperylen Typ I/2 R¹ = Cl, R² = H; X¹ = X² = -O-CO-CH₃

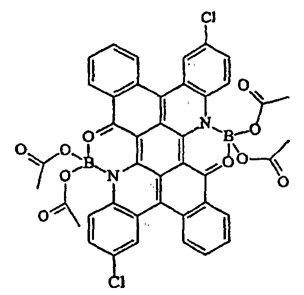

Zu einer Lösung von Boracetat in einer Essigsäure/Acetanhydrid Mischung, hergestellt durch Auflösen von 10 g Borsäure in 250ml Acetanhydrid, werden 0,05 Mol der Ausgangsverbindung **II/2** zugegeben. Es wird so lange unter Rückfluß erhitzt, bis eine fast klare Lösung entstanden ist. Nach einer Heißfiltration läßt man Abkühlen und isoliert das ausgefallene Produkt I/2 durch Absaugen. Ausbeute 92%; mp 379°C. Das Produkt weist in Aceton ein Absorptionsmaximum von 581nm und ein Emissionsmaximum von 630nm auf.

### Beispiel 6:

### Synthese des borkomplexierten Diazaperylen Typ I/3 R¹ = Cl, R² = H; X¹ = X² = -O-CO-C₅H₁₁

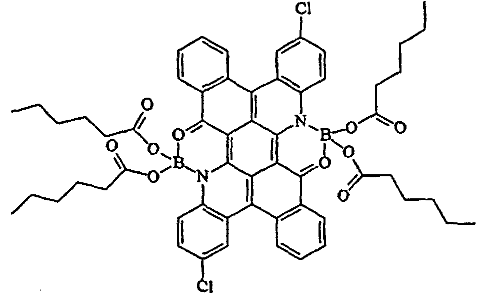

Zu einer Lösung von Borcapronat in einer Capronsäure/Capronsäureanhydrid Mischung, hergestellt durch Auflösen von 10 g Borsäure in 250 ml Capronsäureanhydrid, werden 0,05 Mol der Ausgangsverbindung **II/2** zugegeben. Es wird so lange unter Rückfluß erhitzt, bis eine fast klare Lösung entstanden ist. Nach einer Heißfiltration läßt man Abkühlen und isoliert das ausgefallene Produkt I/3 durch Absaugen. Ausbeute 90%; mp >360°C. Das Produkt weist in Aceton ein Absorptionsmaximum von 582 nm und ein Emissionsmaximum von 630nm auf.

### Beispiel 7:

### Synthese des borkomplexierten Diazaperylen Typ I/4 R¹ = Cl, R² = H; X¹ = X² = -O-CO-C₃H₇

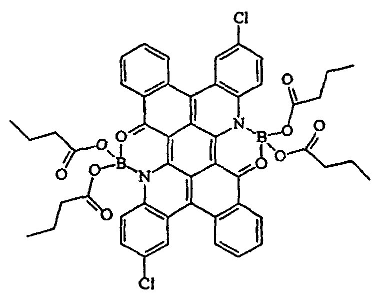

Zu einer Lösung von Borbutyrat in einer Buttersäure/Buttersäureanhydrid Mischung, hergestellt durch Auflösen von 10 g Borsäure in 250 ml Buttersäureanhydrid werden 0,05 Mol der Ausgangsverbindung **II/2** zugegeben. Es wird so lange unter Rückfluß erhitzt, bis eine fast klare Lösung entstanden ist. Nach einer Heißfiltration läßt man Abkühlen und isoliert das ausgefallene Produkt I/4 durch Absaugen. Ausbeute 85%; mp >360°C. Das Produkt weist in Aceton ein Absorptionsmaximum von 582nm und ein Emissionsmaximum von 630nm auf.

### Beispiel 8:

### Synthese des borkomplexierten Diazaperylen Typ I/5 R¹ = R² = Cl; X¹ = X² = -O-CO-CH₃

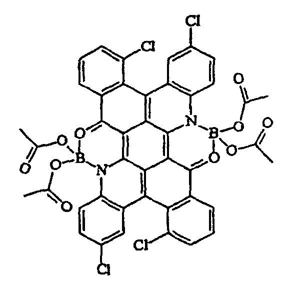

Zu einer Lösung von Boracetat in einer Essigsäure/Acetanhydrid Mischung, hergestellt durch Auflösen von 10 g Borsäure in 250ml Acetanhydrid, werden 0,05 Mol der Ausgangsverbindung **II/3** zugegeben. Es wird so lange unter Rückfluß erhitzt, bis eine fast klare Lösung entstanden ist. Nach einer Heißfiltration läßt man Abkühlen und isoliert das ausgefallene Produkt I/5 durch Absaugen. Ausbeute 82%; mp >360°C. Das Produkt weist in Aceton ein Absorptionsmaximum von 573nm und ein Emissionsmaximum von 620nm auf.

## Patentansprüche

1. Hochkondensierte Borkomplexverbindung der allgemeinen Struktur **I**. 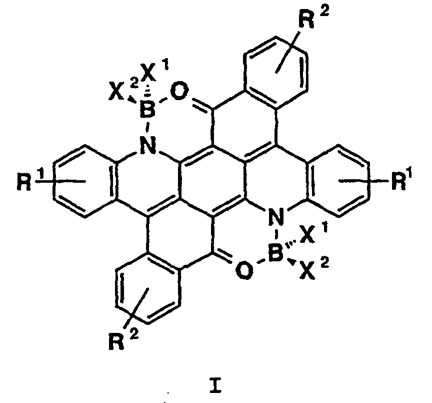 wobei Folgendes gilt:
R¹ und R² die, unabhängig voneinander gleich oder verschieden sein können, stehen für Wasserstoff, Halogen, Pseudohalogen, Nitril- und/oder Nitrogruppe, ein unsubstituiertes oder durch Alkyl, durch Aryl sowie Aryl mit zumindest einem nicht- kohlenstoffatom substituiertes -NR³R⁴, -OR⁵, -PR³R⁴ sowie -SR⁶ und/oder für einen ankondensierten carbocyclischen oder heterocyclischen Ring, wobei im Fall, dass R³ bis R⁶ Alkyl ist, diese Reste verzweigt oder unverzweigt sein können, 1 bis 20 C-Atome enthalten können und verschiedene funktionelle Gruppen mit N,O, S und/oder P-Atomen enthalten können;
X¹ und X² die, unabhängig voneinander gleich oder verschieden sein können, stehen für Halogen, dabei vorzugsweise Fluor, Alkyl- oder Aryloxy, wobei die Alkylgruppierungen verzweigt oder unverzweigt 1 bis 20 C-Atome und verschiedene funktionelle Gruppen mit N,O, S und/oder P-Atomen enthalten können
oder
beide gemeinsam, durch einen zumindest zweizähnigen Liganden mit dem Boratom einen Cyclus bilden, wobei der zumindest zweizähnige Ligand Hydroxy- und/oder Carbonsäuregruppen haben kann und vorzugsweise ein Diol, eine Hydroxycarbonsäure oder eine Dicarbonsäure, wie -OC₂H₄O-, -OC₃H₆O-, Glykolat, Laktat, Tartrat, Sylicylat, Mandelat, Benzilat, 1,2- oder 2,3-Hydroxynaphthoat, Oxalat, Malonat, Alkylmalonat oder Dialkylmalonat ist.

2. Verfahren zur Herstellung der Borkomplexverbindungen nach Anspruch 1, aus einem Diazaperylen **II** 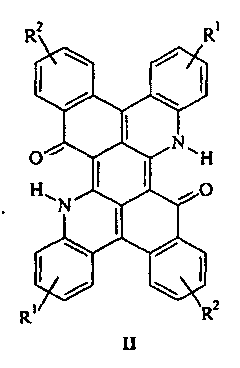 durch Umsetzung mit zumindest einem Borester, einer Carbonsäure, einer Di- oder Oligocarbonsäure, einer hydroxysubstituierten Carbonsäure und/oder mit einem komplexen Addukt eines Borhalogenids.

3. Verfahren nach Anspruch 2, wobei die Umsetzung in zumindest einem elektronendonatorfähigen Lösungsmittel stattfindet.

4. Verwendung einer elektrolumineszierenden hochkondensierten Borkomplexverbindung nach Anspruch 1 als organisches halbleitendes Material in einem organischen elektronischen Bauelement.

5. Verwendung nach Anspruch 4 als organisches halbleitendes Material in einer Loch- und/oder Elektronentransportschicht einer organischen lichtemittierenden Diode (OLED).

6. Verwendung nach Anspruch 4 in einer organischen Solarzelle.

## Claims

1. Highly condensed, boron complex based compound having the general structure I. 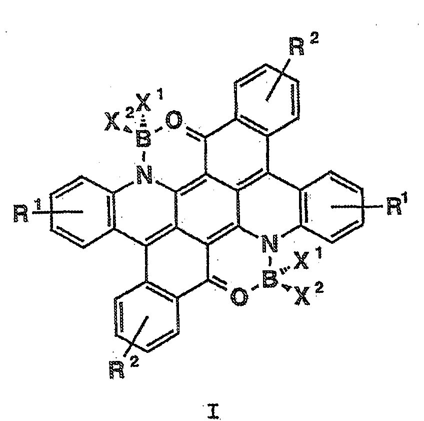 where R¹ and R², which can be the same or different independently of one another, stand for hydrogen, halogen, pseudohalogen, a nitrile and/or nitro group, an unsubstituted or alkyl, aryl and aryl with at least one non-carbon atom substituted -NR³R⁴, -OR⁵, -PR³R⁴ and -SR⁶ and/or for a fused carbocyclic or heterocyclic ring, these groups possibly being branched or unbranched, containing 1 to 20 C atoms and containing various functional groups with N, O, Sand/or P atoms in the event that R³ to R⁶ is alkyl;
where X¹ and X², which can be the same or different independently of one another, stand for halogen, preferably fluorine, alkyl- or aryloxy, the alkyl groupings possibly being branched or unbranched and containing 1 to 20 C atoms and various functional groups with N, 0, S and/or P atoms
or
both jointly forming a cycle with the boron atom through an at least bidentate ligand, the at least bidentate ligand possibly having hydroxy and/or carboxylic acid groups and being preferably a diol, a hydroxy carboxylic acid or a dicarboxylic acid such as -OC₂H₄O-, -OC₃H₆O-, glycolate, lactate, tartrate, sylicylate, mandelate, benzilate, 1,2- or 2,3-hydroxynaphthoate, oxalate, malonate, alkylmalonate or dialkymalonate.

2. Method for producing the boron complex based compounds according to Claim 1, from a diazaperylene II 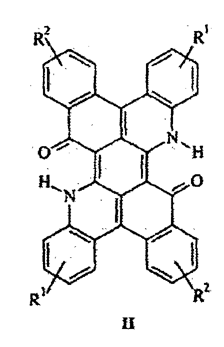 by reaction with at least one boron ester, one carboxylic acid, one di- or oligocarboxylic acid, one hydroxy-substituted carboxylic acid and/or one complex adduct of a boron halogenide.

3. Method according to Claim 2, wherein the reaction takes place in at least one electron-donating solvent.

4. Use of an electroluminescent, highly condensed, boron complex-based compound, according to Claim 1, as an organic semiconducting material in an organic electronic device.

5. Use according to Claim 4 as an organic semiconducting material in a hole and/or electron transfer layer of an organic light-emitting diode (OLED).

6. Use according to Claim 4 in an organic solar cell.

## Revendications

1. Composé complexe du bore, hautement condensé, de structure générale I. 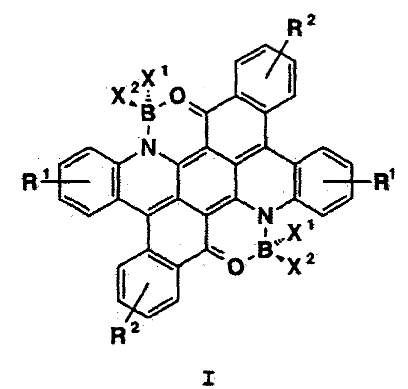 dans laquelle s'applique ce qui suit :
R¹ et R² qui peuvent être, indépendamment l'un de l'autre, identiques ou différents, représentent un atome d'hydrogène, un atome d'halogène, un groupe pseudo-halogène, un groupe nitrite et/ou nitro, un groupe -NR³R⁴, -OR⁵, -PR³R⁴, ainsi que -SR⁶, non substitué ou substitué par un groupe alkyle, par un groupe aryle, ainsi que par un groupe aryle avec au moins un atome non carbone, et/ou un cycle hétérocyclique ou carbocyclique condensé, où, dans le cas où R³ à R⁶ sont des groupes alkyle, ces résidus peuvent être ramifiés ou non ramifiés, peuvent contenir 1 à 20 atomes de carbone, et peuvent contenir différents groupes fonctionnels avec des atomes de N, O, S et/ou P;
X¹ et X² qui peuvent être indépendamment l'un de l'autre identiques ou différents, représentent un atome d'halogène, de préférence dans ce cas un atome de fluor, un groupe alkyloxy ou aryloxy, les groupements alkyle ramifiés et non ramifiés pouvant contenir de 1 à 20 atomes de C, et différents groupes fonctionnels avec des atomes de N, O, S et/ou P
ou
les deux forment conjointement un cycle avec l'atome de bore à l'aide d'un ligand au moins bidenté, ledit ligand au moins bidenté pouvant porter des groupes hydroxy et/ou acide carboxylique et représente de préférence un diol, un acide hydroxycarboxylique, ou un acide dicarboxylique, tels que -OC₂H₄O-, -OC₃H₆O-, un glycolate, lactate, tartrate, salicylate, mandélate, benzylate, 1,2- ou 2,3-hydroxynaphtoate, oxalate, malonate, alkylmalonate ou dialkylmalonate.

2. Procédé pour préparer des composés complexes du bore selon la revendication 1, à partir d'un diazapérylène II 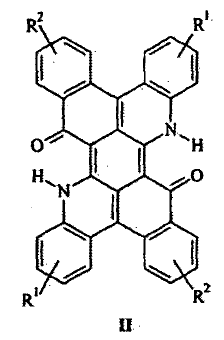 par réaction avec au moins un ester de bore, un acide carboxylique, un acide di- ou oligocarboxylique, un acide carboxylique à substitution hydroxy, et/ou avec un adduit complexe d'un halogénure de bore.

3. Procédé selon la revendication 2, dans lequel la réaction a lieu dans au moins un solvant susceptible de donner des électrons.

4. Utilisation d'un composé complexe du bore hautement condensé électroluminescent selon la revendication 1, en tant que matière semi-conductrice organique dans un composant électronique organique.

5. Utilisation selon la revendication 4, en tant que matière semi-conductrice organique dans une couche de transport de trous et/ou d'électrons d'une diode électroluminescente organique (OLED).

6. Utilisation selon la revendication 4 dans une cellule solaire organique.
